# EUROPEAN PATENT APPLICATION

(11) **EP 1 921 658 A2**
(43) Date of publication of application: **14.05.2008**
(21) Application number: 07115859.6
(22) Date of filing: 06.09.2007
(51) Int. Cl.: H01J 37/32

(54) **System and method for shielding during PECVD deposition processes**

(30) Priority: 09.11.2006 US 558266
(71) Applicant: Applied Materials, Inc., Santa Clara, CA 95054 (US)
(72) Inventor: Stowell, Michael W., Loveland, CO 80538 (US)
(74) Representative: Schickedanz, Willi

(57) **Abstract**

A system and method for plasma enhanced chemical vapor deposition is described. One embodiment includes a process chamber (150); a substrate support (120) positioned inside the process chamber, the substrate support configured to support a substrate (125) on which a film will be deposited; an antenna (110) located inside the process chamber; a radical shield (145) partially surrounding the antenna, the radical shield having an inner volume; a support gas inlet (155) positioned to supply support gas to the inner volume of the radical shield; a precursor gas inlet configured to supply a precursor gas to the inside of the process chamber; at least one aperture (160) in the radical shield, the aperture positioned to enable radicals to escape the inner volume of the radical shield and collide with the precursor gas.

## Description

### FIELD OF THE INVENTION

The present invention relates generally to plasma processes and systems, and more particularly, but not by way of limitation, to systems and methods for controlling radicals in a plasma process and system.

### BACKGROUND OF THE INVENTION

Plasma enhanced chemical vapor deposition (PECVD) is a well-known process for depositing thin films on a variety of substrates. Several industries varying from glass manufacturing to semiconductor manufacturing to plasma display panel manufacturing rely on PECVD systems to deposit thin films upon substrates. PECVD systems vary widely in their application, just as the films they deposit vary widely in their chemistry and quality.

Typical PECVD processes can be controlled by varying process parameters such as gas pressure, power, power pulsing frequency, power duty cycle, pulse shape, and several other parameters. Despite this high degree of customization available in PECVD processes, the industry is continually searching for new ways to improve the PECVD process and to gain more control over the process. In particular, the PECVD industry seeks to utilize PECVD over a wider range of process parameters.

Currently, PECVD can only be used in a limited set of conditions. For other conditions, alternative deposition processes must be used. These alternative deposition processes, such as electron cyclotron resonance (ECR) and sputtering, are not always optimal for many applications. Accordingly, the industry has been searching for ways to extend the application of PECVD into areas traditionally reserved for these alternative deposition methods.

Although present devices and methods are functional, they are not sufficiently accurate or otherwise satisfactory. Accordingly, a system and method are needed to address the shortfalls of present technology and to provide other new and innovative features.

### SUMMARY OF THE INVENTION

Exemplary embodiments of the present invention that are shown in the drawings are summarized below. These and other embodiments are more fully described in the Detailed Description section. It is to be understood, however, that there is no intention to limit the invention to the forms described in this Summary of the Invention or in the Detailed Description. One skilled in the art can recognize that there are numerous modifications, equivalents and alternative constructions that fall within the spirit and scope of the invention as expressed in the claims.

The present invention can provide a system and method for plasma enhanced chemical vapor deposition. One embodiment includes a process chamber; a substrate support positioned inside the process chamber, the substrate support configured to support a substrate on which a film will be deposited; an antenna located inside the process chamber; a radical shield partially surrounding the antenna, the radical shield having an inner volume; a support gas inlet positioned to supply support gas to the inner volume of the radical shield; a precursor gas inlet configured to supply a precursor gas to the inside of the process chamber; at least one aperture in the radical shield, the aperture positioned to enable radicals to escape the inner volume of the radical shield and collide with the precursor gas.

### BRIEF DESCRIPTION OF THE DRAWINGS

Various objects and advantages and a more complete understanding of the present invention are apparent and more readily appreciated by reference to the following Detailed Description and to the appended claims when taken in conjunction with the accompanying Drawings wherein:
FIGURE 1 is a block diagram of a conventional PECVD system;
FIGURE 2 is a block diagram of a conventional PECVD system in operation;
FIGURE 3 is an illustration of radicals near the antenna in a conventional PECVD system;
FIGURE 4 illustrates a containment shield constructed in accordance with one embodiment of the present invention;
FIGURE 5 illustrates a cross section of a PECVD system constructed in accordance with one embodiment of the present invention;
FIGURE 6 is a diagram of the typical pressure ranges in which conventional deposition systems operate; and
FIGURE 7 is a chart illustrating the exemplary operating ranges for a PECVD system operated in accordance with one embodiment of the present invention.

### DETAILED DESCRIPTION

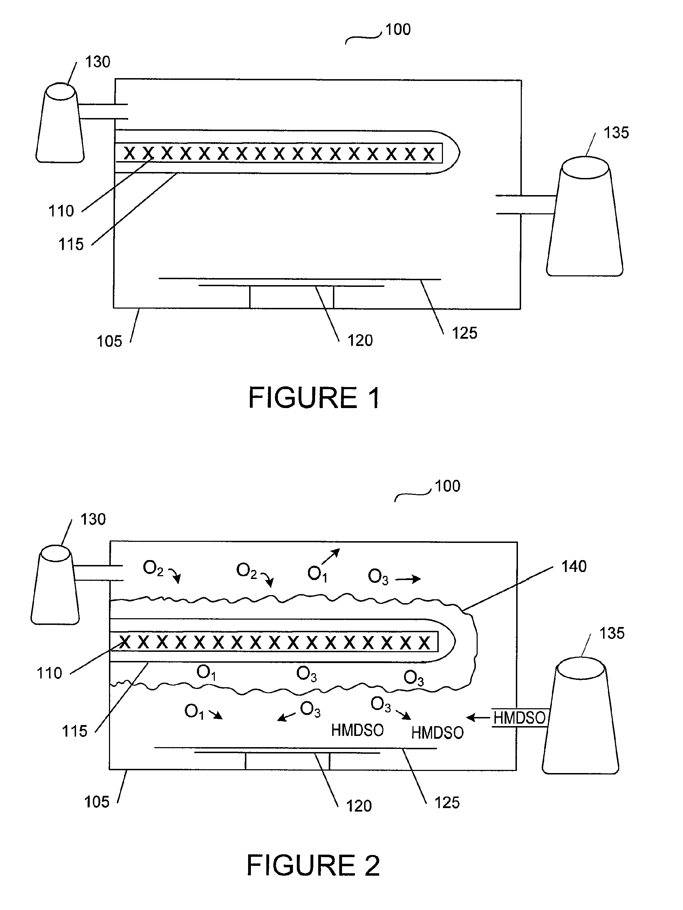

Referring now to the drawings, where like or similar elements are designated with identical reference numerals throughout the several views, and referring in particular to FIGURES 1 and 2, which illustrate a conventional block diagram PECVD system 100. This PECVD system includes a process chamber 105, an antenna 110, a protective dielectric sheath 115, a substrate support 120, a substrate 125, a support gas source 130, and a precursor gas source 135. These types of systems are well known in the art and not described fully herein.

Figure 2 illustrates the operation of a conventional PECVD system during the process of depositing a dielectric layer of SiO₂ onto the substrate. Those of skill in the art will understand that other precursor gases and other support gases can be used to achieve the desired film chemistry and that the O₂ and HMDSO gases shown in Figure 2 are for illustration purposes only.

In general operation, the support gas O₂, in this embodiment, is introduced from the support gas source 130. The O₂ is fractionalized by the plasma 140 formed around the antenna 110, thereby forming O₁ and O₃ radicals. These and other plasma radicals collide with other O₂ molecules, thereby forming more radicals. These radicals then collide with the HMDSO molecules, causing the HMDSO to disassociate and reform into SiOx and other waste material. The SiOx combines with other oxygen radicals, thereby forming SiO₂ as it deposits upon the substrate 125. Some of the waste material, such as OH and H₂O, also deposit on the substrate 125, but much of it is pumped off using an exhaust pump.

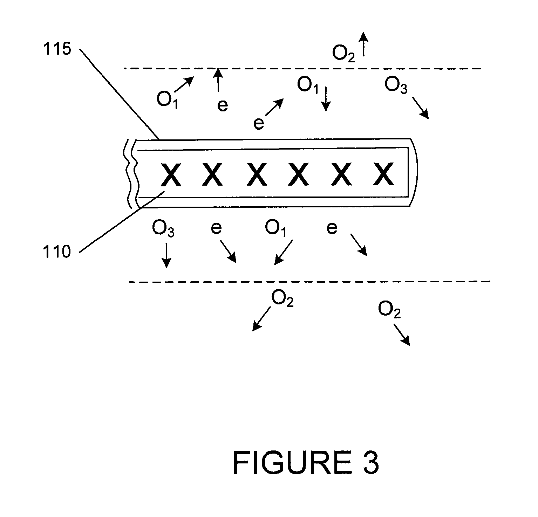

Referring now to Figure 3, it illustrates a blow-up of the area immediately surrounding the antenna 110 and protective sheath 115. As previously described, the O₁ and O₃ radicals collide with O₂ molecules introduced from the supporting gas source. Upon collision, the O₂ is disassociated into O₁ and O₃. These new radicals then collide with other O₂ molecules, forming more radicals.

In a typical fractionalization process of this type, only a small fraction of the supporting gas is actually fractionalized. For example, as little as 2% of the O₂ is fractionalized in a typical PECVD system. The amount of gas fractionalized is determined by the pressure of the supporting gas and the amount of power applied to the antenna. The relationship between pressure and power is defined by the Pashen curve for any particular supporting gas.

Most fractionalization of the supporting gas is caused by electrons generated by the power applied to the antenna. Some fractionalization is also caused by ions and by radicals. The effectiveness of electrons in fractionalizing a supporting gas is directly linked to electron density. In areas of higher electron density, fractionalization rates are higher for the same supporting gas pressures.

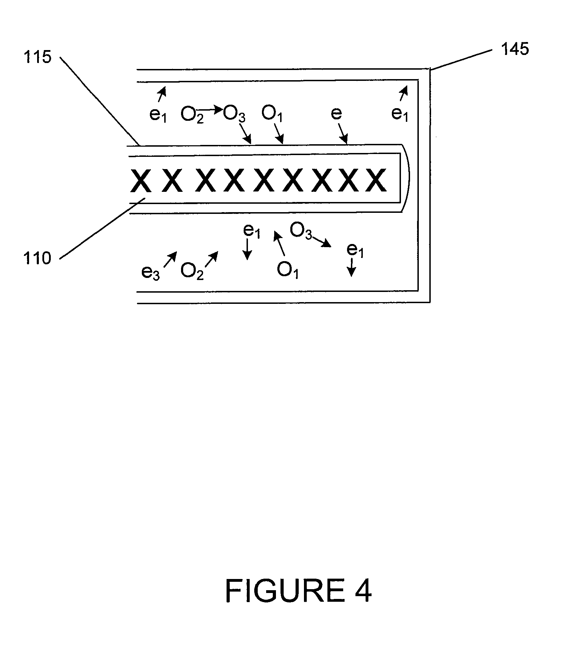

It has been discovered that fractionalization efficiency can be greatly enhanced by utilizing a containment shield near the antenna. The containment shield 145, shown in Figure 4, is generally formed of a dielectric material, such as quartz, and provides a volume around the antenna 110 into which the supporting gas can be pumped. The exact volume of the containment shield 145 and the distance between the antenna 110 and the inner surface of the containment shield can be varied based upon the desired film chemistry, the overall construction of the PECVD system and the desired gas pressures.

The containment shield 145 acts to contain electrons that would otherwise escape. By containing these electrons, the electron density around the antenna 110 can be increase at distances further from the antenna. And by increasing electron density, the plasma can be extended further with the same process parameters - meaning that the fractionalization rate can be increased without changing other process parameters.

The containment shield 145 also prevents radicals and ions from escaping. This can help the fractionalization efficiency and prevents generated radicals and ions from being wasted. And by preserving these particles, the PECVD system can be operated more efficiently.

It should be noted that these embodiments are not limited to a PECVD system. Those of skill in the art could extend the concepts of the present invention to cover any type of plasma system.

The containment shield 145 also advantageously provides better control over supporting gas pressures around the antenna. First, the containment shield helps provide a more uniform supporting gas pressure than was possible without the containment shield 145. This more uniform pressure allows the fractionalization rate to be better controlled and thus increased.

Second, the containment shield 145 provides the ability to have a different pressure within the containment shield 145 than in the remaining portions of the process chamber. This is advantageous because a higher pressure can be maintained within the containment shield 145 and a lower pressure can be maintained in the remaining portions of the process chamber. The result of this variable pressure allows more radicals to be produced at an overall lower process chamber pressure. This type of control allows PECVD processes to be run at significantly lower process chamber pressures than previously possible.

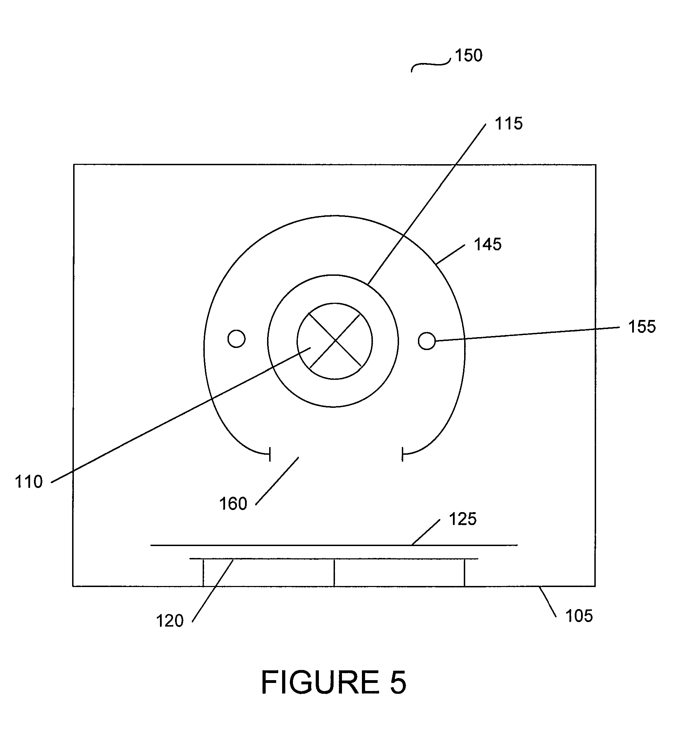

Figure 5 illustrates a cross section of a PECVD system 150 in accordance with one embodiment of the present invention. This system illustrates the process chamber 105, the substrate 125, the substrate support 120, the antenna 110, the protective sheath 115, the containment shield 145, and two supporting gas inlets 155. The supporting gas inlets 155 are located inside the containment shield 145 in this embodiment.

The containment shield 145 includes an aperture 160 nearest the substrate. It is through this aperture 160 that the radicals escape and collide with the precursor gas. The size of this aperture 160 can be varied either manually or electronically to control the number of radicals escaping from the containment shield. It can also be a fixed-size aperture.

In some embodiments, the pressure within the containment shield 145 can be higher than the pressure outside the containment shield 145. Thus, the general PECVD process can be operated at a lower pressure while the plasma enhancement process and the radical production process can be operated at a much higher pressure. As previously discussed, pressure is a key factor in the fractionalization efficiency of the support gas. Up to a certain point, higher pressure enables higher fractionalization efficiencies. Thus, the higher pressure allowed inside the containment shield 145 enhances the fractionalization efficiencies.

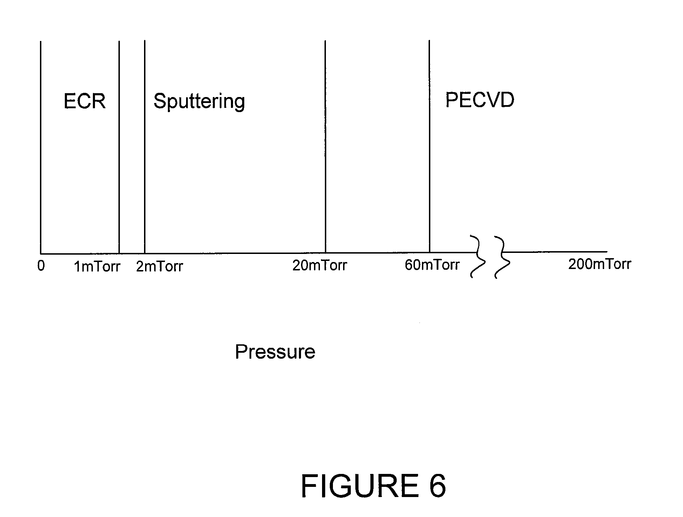

Referring now to Figure 6, it illustrates the pressure ranges in which typical deposition processes operated. For example, ECR typically operates in the very low pressure ranges in the 1 millitorr range. Sputtering typically operates in the 2 millitorr to 20 millitorr range, and PECVD typically operates at higher pressures above 60 millitorr.

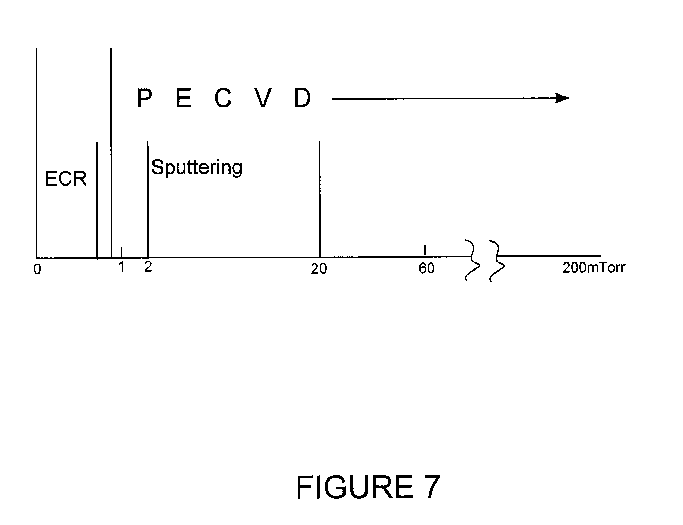

But as previously described, the PECVD industry has been looking for methods to expand PECVD operation into the lower pressure ranges. And embodiments of the present invention provide methods to expand PECVD into the very low pressure ranges. For example, Figure 7 shows that PECVD systems that utilize a containment shield in accordance with embodiments of the present invention can be operated in the same ranges as ECR and sputtering. Early experiments have shown that the use of a containment shield in PECVD systems allows those systems to be operated at pressures below 1 millitorr. Such operation was previously not possible.

In conclusion, the present invention provides, among other things, a system and method for plasma enhanced chemical vapor deposition. Those skilled in the art can readily recognize that numerous variations and substitutions may be made in the invention, its use and its configuration to achieve substantially the same results as achieved by the embodiments described herein. Accordingly, there is no intention to limit the invention to the disclosed exemplary forms. Many variations, modifications and alternative constructions fall within the scope and spirit of the disclosed invention as expressed in the claims.

## Claims

1. A plasma deposition system, the system comprising:
a process chamber;
a substrate support positioned inside the process chamber, the substrate support configured to support a substrate on which a film will be deposited;
an antenna located inside the process chamber;
a containment shield partially surrounding the antenna, the containment shield having an inner volume;
a support gas inlet positioned to supply support gas to the inner volume of the containment shield;
a precursor gas inlet configured to supply a precursor gas to the inside of the process chamber; and
at least one aperture in the containment shield, the aperture positioned to enable radicals to escape the inner volume of the radical shield and collide with the precursor gas.

2. The system of claim 1, wherein the aperture is a variable aperture.

3. The system of claim 1, wherein the containment shield comprises a dielectric material.

4. The system of claim 1 further comprising:
an aperture control configured to vary the aperture responsive to a variation in a plasma deposition process parameter.

5. A plasma enhanced chemical vapor deposition (PECVD) system, the system comprising:
a process chamber; and
a containment chamber located inside the process chamber, the containment chamber including an aperture that enables radicals to leave the containment chamber and collide with a precursor gas.

6. A method of operating a PECVD system, the method comprising:
providing a process chamber;
providing a containment chamber;
operating the process chamber at a first gas pressure; and
operating the containment chamber at a second gas pressure, wherein the second gas pressure is higher than the first gas pressure.

7. The method of claim 6, further comprising:
introducing a support gas to the containment chamber; and
introducing a precursor gas to the process chamber.

8. A method for creating a substrate using plasma enhanced chemical vapor deposition, the method comprising:
introducing a support gas to a containment chamber;
introducing a precursor gas to a process chamber;
generating radicals in the containment chamber;
disassociating the precursor gas using the generated radicals;
depositing at least portions of the disassociated precursor gas onto the substrate, thereby forming a film on the substrate.

9. The method of claim 8, further comprising:
operating the containment chamber at a first gas pressure; and
operating the process chamber at a second gas pressure; and
wherein the first gas pressure is higher than the second gas pressure.

10. The method of claim 8, further comprising:
varying the size of an aperture in the containment chamber to control the number of radicals in the radical containment chamber.
